# EUROPEAN PATENT SPECIFICATION

(11) **EP 0 615 338 B1**
(45) Date of publication and mention of the grant of the patent: **26.05.1999**
(21) Application number: 94301807.7
(22) Date of filing: 14.03.1994
(51) Int. Cl.: H03H 3/04

(54) **Method of adjusting frequency of NS-GT cut quartz resonator**
Verfahren zur Abstimmung der Frequenz von einem in NS-GT-Richtung geschnittenen Quarzresonator
Procédé pour ajuster la fréquence d'un résonateur à quartz de taille NS-GT

(30) Priority: 12.03.1993 JP 52480/93
(43) Date of publication of application: 14.09.1994
(73) Proprietor: SEIKO ELECTRONIC COMPONENTS LTD., Sendai-shi Miyagi (JP)
(72) Inventor: Kawashima, Hirofumi, c/o Seiko Electr. Comp. Ltd., Sendai-shi, Miyagi (JP)
(74) Representative: Sturt, Clifford Mark

(56) References cited:
- 36th ANNUAL FREQUENCY CONTROL SYMPOSIUM 1982, 2-4 JUNE 1982, PHILADELPHIA (US) P.90-96; O.OCHIAI et al: 'A METHOD OF ADJUSTING RESONANT FREQUENCY AND FREQUENCY-TEMPERATURE COEFFICIENTS OF MINIATURIZED GT CUT QUARTZ RESONATORS'

## Description

The present invention relates to a coupling quartz resonator, particularly, of a GT cut quartz resonator consisting of a vibrational portion and two supporting portions (hereinafter referred to as "NS-GT cut resonator") and a method of adjusting the frequency of a NS-GT cut resonator. In particular, the present invention relates to an adjustment method for obtaining a GT cut quartz resonator that has a remarkably excellent frequency-to-temperature characteristic (hereinafter simply referred to as "temperature characteristic").

Recently, photolithographic processes using IC technology have been applied to resonator manufacture which results in the production of a resonator which is remarkably downsized. For example, when such a method is applied to the NS-GT cut resonator it is capable of making its thickness considerably reduced to enable the resonator to be remarkably downsized yet have an excellent temperature characteristic.

Two vibration modes are utilized for the NS-GT cut resonator. That is to say, the coupling of a primary vibration and a subvibration. The temperature characteristic is determined by the difference in resonant frequency between the primary vibration and the subvibration and the intensity of the respective vibrations. In particular, if the ratio of the vibration intensity between the primary vibration and subvibration is different, the coupled resonant frequency therebetween is also made different. In order to obtain a good temperature characteristic then one must match the difference in the resonant frequency with each of the resonators.

For that reason, it takes a long time to adjust the resonant frequency, which is a factor in the increase of the costs. Moreover, this system is unsuited for mass production, which is one of the reasons why resonators of this type are not much used.

As described above, there has remained this problem that a NS-GT cut resonator which has a remarkably excellent temperature characteristic cannot be obtained in a short time and also with ease. In other words, this means that an inexpensive resonator cannot be obtained. In an article by O. Ochiai et al.: "A Method of Adjusting Resonant Frequency and Frequency-Temperature Coefficients of Minaturized GT Cut Resonators" (36th Annual Frequency Control Symposium - 1982, 2-4 June 1982, Philadelphia (US), p.90-96), there is a disclosed a method of adjusting frequency temperature coefficients and the resonant frequency of the principle vibration of a GT type resonator by the addition or elimination of weights.

The present invention solves the above mentioned problem by provision of a method which is set out in Claim 1.

There exists a given relationship between said normalized frequency and said primary temperature coefficient to set said primary temperature coefficient to substantially zero. There exists a given relationship between the normalized frequency and the first order temperature coefficient. Therefore, this normalized frequency is adjusted in such a manner that the first order temperature coefficient is adjusted to substantially zero.

As a result, a NS-GT quartz resonator with a remarkably excellent temperature characteristic can be obtained.

Embodiments of the present invention will now be described with reference to the accompanying drawings, of which:
Figure 1 shows one example of electrodes and the configuration of a NS-CT cut resonator which are applied to the present invention, in which Figure 1A is a front view thereof and Figure 1B is a top view thereof;
Figure 2 shows an electrical equivalent circuit of the NS-GT cut resonator applied to the present invention;
Figure 3 shows the NS-GT cut resonator of the present invention, especially, the weights adhered to the resonator for adjusting the first order temperature coefficient a which are applied to the present invention;
Figure 4 shows changes in the resonant frequencies of the primary vibration and the subvibration against the weight variable;
Figure 5 shows a relationship between a normalized frequency δ and the first order temperature coefficient α₊ ;
Figure 6 shows five samples of the frequency-to-temperature characteristic of the NS-GT cut resonator formed by the etching method according to the prior art;
Figure 7 shows five samples of the frequency-to-temperature characteristic which have been adjusted in accordance with the method of the present invention; and
Figure 8 shows steps of forming the resonator and adjusting the normalized frequency of the resonator.

An embodiment of the present invention will now be concretely described.

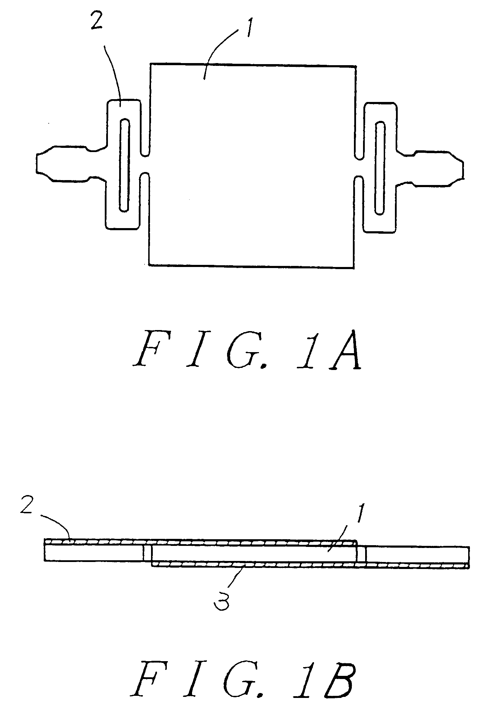

Figure 1 shows one example of electrodes and the configuration of a NS-GT cut resonator, which are applied to the present invention. Figure 1(A) shows a front view thereof and Figure 1(B) shows a top view thereof. On the obverse and reverse sides of a quartz 1, electrodes 2 and 3 are deposited, respectively. The resonator can be easily excited by applying an alternating voltage between both the electrodes.

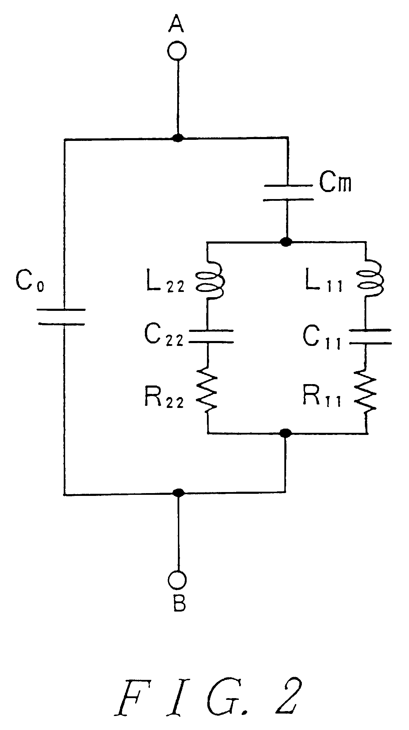

Figure 2 shows an electrical equivalent circuit of the NS-GT cut resonator which is applied to the present invention. The circuit includes a series arm (L₁₁, C₁₁, R₁₁) of a primary vibration, a series arm (L₂₂, C₂₂ R₂₂) of a subvibration, a coupling capacitance Cm and a parallel capacitance Cₒ. Therefore, the resonant frequency of the NS-GT cut resonator, which couples the two vibration modes with each other, is obtained from this equivalent circuit. Hereinafter, the resonant frequency f will be described in detail together with the principle of adjusting the temperature characteristic.

The electrical equivalent circuit shown in Figure 2 can be represented by an impedance Z. That is to say it is represented by the sum of a real part Rei (where i = 1, 2, 3...) and an imaginary part jxe (Z = Rei + jxe). Since the mechanical loss resistances R₁₁ and R₂₂ are very small then R₁₁ ≈ R₂₂ ≈ 0. Hence Z ≈ jxe where Xe is represented as follows:-$\text{[EX. 1]} \text{Xe} \text{=} \frac{\text{-1}}{\text{2π} {\text{fC}}_{\text{0}}} \frac{\text{(} \frac{{\text{f}}^{\text{2}}}{{\text{f}}_{\text{1}}^{\text{2}}} \text{-1)(} \frac{{\text{f}}^{\text{2}}}{{\text{f}}_{\text{2}}^{\text{2}}} \text{-1)-} \frac{{\text{C}}_{\text{1}} {\text{C}}_{\text{2}}}{{\text{Cm}}^{\text{2}}}}{\text{[(} \frac{{\text{f}}^{\text{2}}}{{\text{f}}_{\text{1}}^{\text{2}}} \text{-1)(} \frac{{\text{f}}^{\text{2}}}{{\text{f}}_{\text{2}}^{\text{2}}} \text{-1)-} \frac{{\text{C}}_{\text{1}} {\text{C}}_{\text{2}}}{{\text{Cm}}^{\text{2}}} \text{-{} \frac{{\text{C}}_{\text{2}}}{{\text{C}}_{\text{0}}} \text{(} \frac{{\text{f}}^{\text{2}}}{{\text{f}}_{\text{1}}^{\text{2}}} \text{-1+} \frac{{\text{C}}_{\text{1}}}{\text{Cm}} \text{)+} \frac{{\text{C}}_{\text{1}}}{{\text{C}}_{\text{0}}} \text{(} \frac{{\text{f}}^{\text{2}}}{{\text{f}}_{\text{2}}^{\text{2}}} \text{-1+} \frac{{\text{C}}_{\text{2}}}{{\text{C}}_{\text{0}}} \text{)}]}}$ where f₁ and f₂ are the uncoupled resonant frequencies of the primary vibration and the subvibration, respectively, and C₁ and C₂ are defined as follows:$\text{[EX.2]} \frac{\text{1}}{{\text{C}}_{\text{1}}} \text{=} \frac{\text{1}}{{\text{C}}_{\text{11}}} \text{+} \frac{\text{1}}{{\text{C}}_{\text{m}}} \text{,} \frac{\text{1}}{{\text{C}}_{\text{2}}} \text{=} \frac{\text{1}}{{\text{C}}_{\text{22}}} \text{+} \frac{\text{1}}{{\text{C}}_{\text{m}}}$

The coupled resonant frequencies of the primary vibration and the subvibration are represented by f₊ and f₋ respectively. The following relation is obtained from expression (EX. 1):${\text{[EX.3] (1- K}}^{\text{2}} {\text{m)f}}_{\text{1}} {}^{\text{2}} {\text{f}}_{\text{2}} {}^{\text{2}} {\text{= f}}_{\text{+}} {}^{\text{2.}} {\text{f}}_{\text{-}} {}^{\text{2}}$ where K²m = C₁C₂/C²m and Km is a coupling coefficient. When the (EX.3) is differentiated by temperature t once and represented by · ≡ ∂/∂t with the first order temperature coefficients of the uncoupled primary vibration and subvibration as α₁ and α₂, the first order temperature coefficients of the coupled primary vibration and subvibration as α₊ and α₋, the first order temperature coefficient of the coupling coefficient as αₖₘ, the function of the coupling coefficient Km as K, this leads as follows:

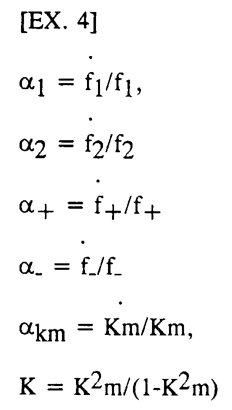

The following significant relationship is obtained from the expressions (EX.3) and EX.4. That is,${\text{α}}_{\text{+}} {\text{+ α}}_{\text{-}} {\text{= α}}_{\text{1}} {\text{+ α}}_{\text{2}} {\text{- Kα}}_{\text{km}}$

The sum of α₁ and α₋ becomes a constant value. When a frequency ratio f_{MP} and R are newly applied where f_{MP} = f₋/f₊ and R = f₂/f_{-,} then α₊ is rewritten as follows:${\text{[EX 5] α}}_{\text{+}} \text{=} \frac{{\text{α}}_{\text{1}} {\text{- α}}_{\text{2}} {\text{f}}_{\text{MP}}^{\text{2}}}{\text{1-} {\text{f}}_{\text{MP}}^{\text{2}}} \text{+} \frac{{\text{f}}_{\text{MP}}^{\text{2}}}{\text{1-} {\text{f}}_{\text{MP}}^{\text{2}}} \text{{} \text{K} {\text{α}}_{\text{km}} \text{-} {\text{R}}^{\text{2}} {\text{(α}}_{\text{1}} {\text{- α}}_{\text{2}} \text{)}}$ A normalized frequency δ can be newly defined as follows:$\text{[EX.6] δ =} \frac{{\text{f}}_{\text{MP}}^{\text{2}}}{\text{1-} {\text{f}}_{\text{MP}}^{\text{2}}}$

Therefore, the expression (EX. 6) is represented as follows${\text{[EX. 7] α}}_{\text{+}} \text{= mδ + n}$ where${\text{m = Kα}}_{\text{km}} {\text{- R}}^{\text{2}} {\text{(α}}_{\text{1}} {\text{- α}}_{\text{2}} \text{)}$${\text{n = (α}}_{\text{1}} {\text{- α}}_{\text{2}} {\text{f}}_{\text{Mp}} {}^{\text{2}} {\text{)/(1 - f}}_{\text{MP}} {}^{\text{2}} \text{)}$ m and n have respective predetermined values while the frequency ratio f_{MP} is changed a little. Consequently, when an inclination m is determined, f_{MP}, when α₊ = 0, can be easily calculated from the equation (EX.7). As will be described later, m is calculated through experiment.

Hereinafter, the method of adjusting the temperature coefficient will be described on the basis of the adjustment principle.

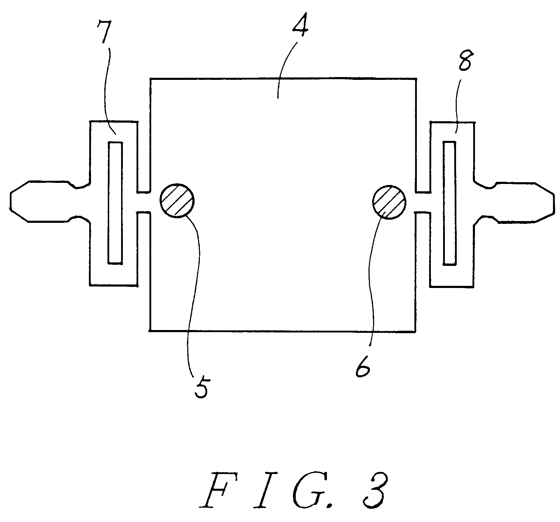

Figure 3 shows the NS-GT cut resonator 4 of the present invention and the respective positions of weights 5 and 6 adhered to the resonator 4 by an evaporation method to adjust α₊, which is applied to the present invention. The weights 5 and 6 are deposited on both ends of the resonator with supporting portions 7 and 8 in the longitudinal direction. Of course, only one weight may be deposited at one end.

The coupled resonant frequency f₋ of the subvibration can be remarkably changed by adding the weights 5 and 6 at those positions. In this embodiment, these weights are located in the centre of the resonator in the widthwise direction.

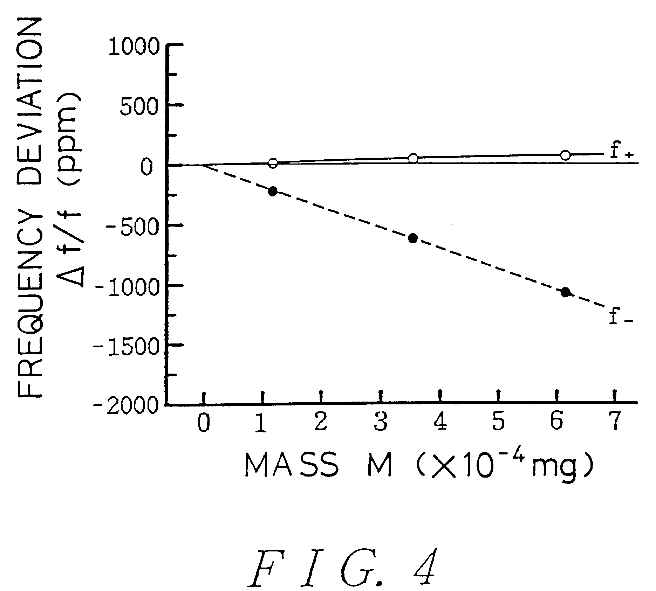

Figure 4 shows the change of frequency relative to the quantity of the weights 5 and 6 which have been added. As is apparent from Figure 4, it has been found that f₋ (coupled resonant frequency of the subvibration) is largely changed while f₊ (coupled resonant frequency of the primary vibration) is almost stable. It means that the coupling state between the primary vibration and the subvibration is changed according to the weights 5 and 6 with this relationship. In other words, α₊ can be adjusted.

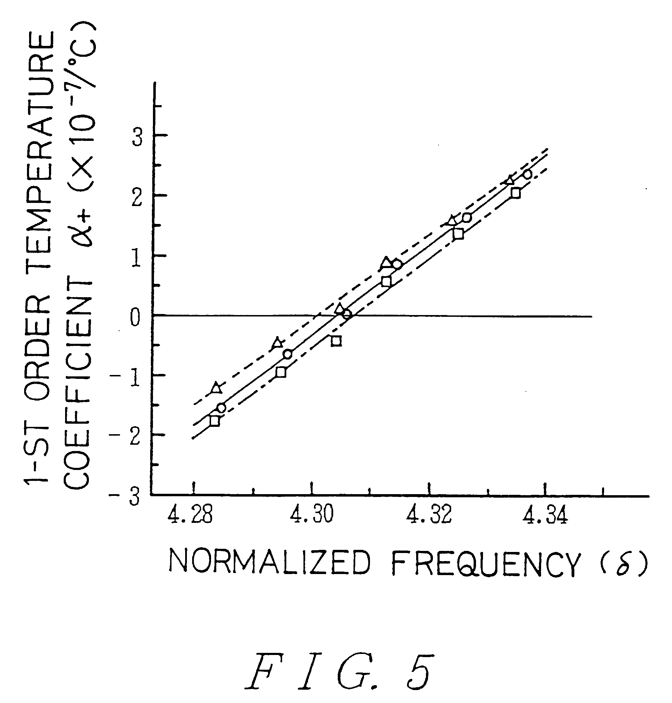

Figure 5 shows a relationship between the normalized frequency δ and the first order temperature coefficient α₊ of the primary vibration when the primary and subvibrations are coupled with each other. As was described in explanation of the adjustment principle, α₊ and δ are proportional, and its inclination m has a substantially given value. For example, in the case where the frequency f of this resonator is 2.1 MHz, m is 75 x 10⁻⁷⁺/°C. The adjustment results are indicated below.

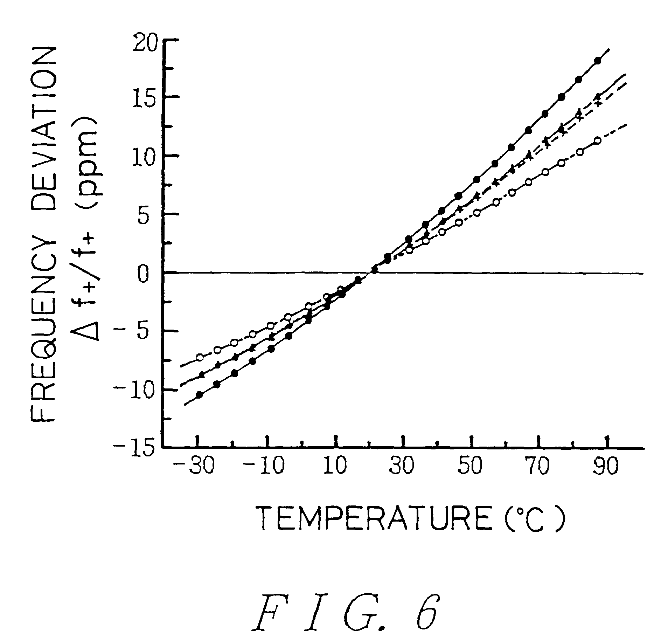

Figure 6 shows five samples of the frequency-to-temperature characteristic of the NS-GT cut resonator which has been formed by the etching method and adjusted according to the prior art. The resonator has been adjusted so as to enable the frequency change to vary ± 20 ppm over the wide temperature range of -30 to +85 °C. In this case, α₊ (first order coupled temperature coefficient) is a positive value. In general, the value of α₊ is set to 1 to 3 x 10⁻⁷/°C. On the other hand, the absolute values of the second and third order temperature coefficients β₊ and γ₊ at this case become smaller than 5 x 10⁻¹⁰/°C² and 6 x 10⁻¹³/°C³, respectively. Therefore by setting α₊ to approximately zero, it is expected that the NS-GT cut resonator has an excellent temperature.

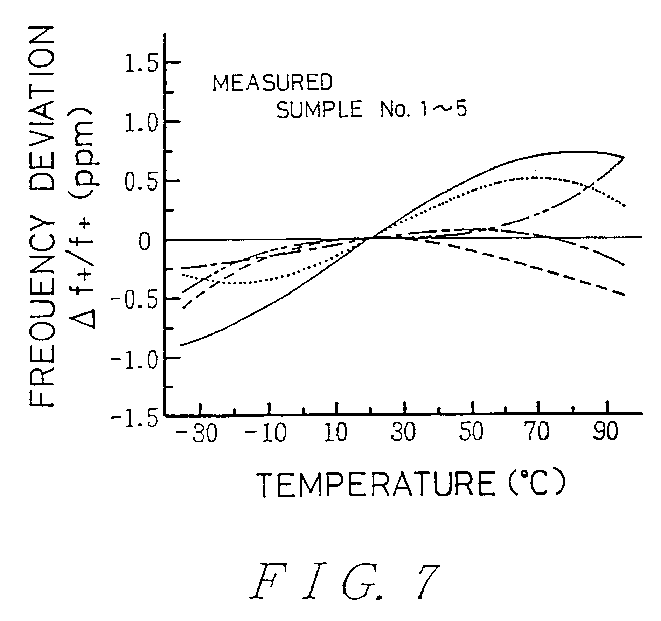

Figure 7 shows five samples of the frequency-to-temperature characteristic when the first order temperature coefficient α₊ is adjusted to approximately zero according to the method of the invention,

As a consequence of the present invention, the coupled frequency f₊ change is within ± 1.0 ppm over the wide temperature range of - 30 to 85°C. Hence a NS-GT cut resonator with an extremely excellent temperature characteristic can be obtained.

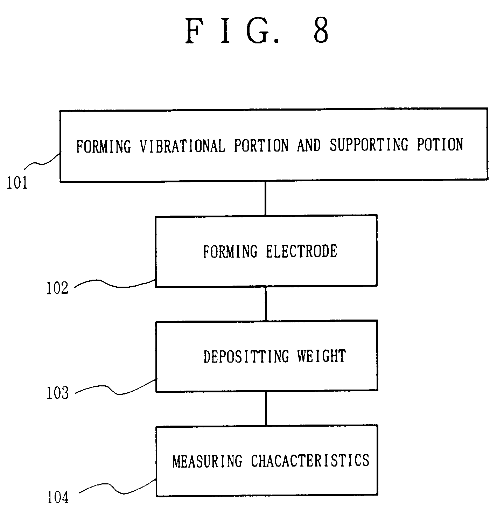

Figure 8 shows steps of forming the resonator and adjusting the normalized frequency of the resonator according to the relationship between the normalised frequency and the first order temperature coefficient to adjust the first order temperature coefficient substantially to zero. In Figure 8, step 101 forms the vibrational portion and supporting portions of the present invention, step 102 forms the electrodes, step 103 deposits the weights on the vibrator and step 104 measures the temperature characteristics.

As was described above, the present invention proposes the method of adjusting the temperature coefficient, which has the following remarkable advantages:
(1) Since the first order temperature coefficient α₊ and the normalised frequency δ are proportional to each other δ can be adjusted to enable α₊ = 0 to be easily calculated and the NS-GT cut resonator has a remarkably excellent temperature characteristic;
(2) Since the normalised frequency δ can be very simply adjusted, the resonator can be obtained inexpensively; and
(3) Since adjustment by evaporation does not cause damage to the resonator, the resonator with a reduced mechanical loss resistance and a high Q value can be obtained. Moreover, the resonator has an excellent ageing characteristic.

The aforegoing description has been given by way of example only and it will be appreciated by a person skilled in the art that modifications can be made without departing from the scope of the present invention as defined by the appended claim.

## Claims

1. A method of adjusting a frequency-to-temperature coefficient of an NS-GT cut quartz resonator (1) in which at least one weight (5, 6) for adjusting a temperature characteristic is deposited onto at least one of both ends of said NS-GT cut quartz resonator in the longitudinal direction thereof and the center of the width direction thereof, said method being characterised by:
determining a relationship between a primary temperature coefficient α₊ and a normalized frequency δ, with δ = f²_{MP}/(1-f²_{MP}) where f_{MP} = f₋/f₊ with f₊ and f₋ being respectively the coupled resonant frequencies of the primary vibration and the subvibration of the resonator;
forming a resonator having a characteristic such that the primary temperature coefficient of said formed resonator has a value which is shifted from a desired value; and
determining the mass of said at least one weight (5, 6) required to give a desired value of δ; and
depositing said at least one weight on the resonator, wherein said desired value of δ is chosen to give a primary temperature coefficient α₊ of zero without change of the coupled resonant frequency of the primary vibration f₊.

## Patentansprüche

1. Verfahren zur Abstimmung eines Frequenz-Temperatur-Koeffizienten eines NS-GT-geschnittenen Quarzresonators (1), bei dem mindestens ein Gewicht (5, 6) zur Abstimmung einer Temperatur-Charakteristik auf mindestens einem der beiden Enden des NS-GT-geschnittenen Quarzresonators in dessen Längsrichtung und in der Mitte von dessen Breitenrichtung abgelagert wird, wobei das Verfahren gekennzeichnet ist durch:
- die Bestimmung eines Zusammenhangs zwischen einem primären Temperaturkoeffizienten α₊ und einer normierten Frequenz δ, wobei δ = f²_{MP}/(1-f²_{MP}), wobei f_{MP} = f₋/f₊, wobei f₊ und f₋ die gekoppelten Resonanzfrequenzen der Primärschwingung bzw. der Unterschwingung des Resonators sind,
- die Bildung eines Resonators mit einer solchen Charakteristik, daß der primäre Temperaturkoeffizient des gebildeten Resonators einen Wert besitzt, der gegenüber einem gewünschten Wert verschoben ist, und
- die Bestimmung der Masse des mindestens einen Gewichts (5, 6), die erforderlich ist, um einen gewünschten Wert von δ zu erhalten, und
- das Ablagern des mindestens einen Gewichts auf dem Resonator, wobei der gewünschte Wert von δ so gewählt wird, daß sich ein primärer Temperaturkoeffizient α₊ von 0 ergibt, ohne die gekoppelte Resonanzfrequenz der Primärschwingung f₊ zu ändern.

## Revendications

1. Procédé de réglage d'un coefficient fréquence-température d'un résonateur à quartz taillé en NS-GT (1) dans lequel au moins un poids (5, 6) servant à régler une caractéristique de température est déposé sur au moins l'une des deux extrémités dudit résonateur à quartz taillé en NS-GT, dans la direction longitudinale de ce dernier et au centre de la direction transversale de ce dernier, ledit procédé étant caractérisé par les étapes qui consistent à :
déterminer une relation entre un coefficient de température principal α₊ et une fréquence normalisée δ, avec δ = f²_{MP}/(1-f²_{MP}), où f_{MP} = f₋/f₊, f₊ et f₋ étant respectivement les fréquences de résonance accouplées de la vibration principale et de la vibration secondaire du résonateur ;
former un résonateur ayant une caractéristique telle que le coefficient de température principal dudit résonateur formé ait une valeur décalée d'une valeur souhaitée ; et
déterminer la masse dudit au moins un poids (5, 6) requis pour donner une valeur souhaitée à δ ; et
déposer ledit au moins un poids sur le résonateur, dans lequel ladite valeur souhaitée de δ est choisie pour donner un coefficient de température principal α₊ de zéro sans changement de la fréquence de résonance accouplée de la vibration principale f₊.
